# EUROPÄISCHE PATENTANMELDUNG

(11) **EP 4 016 436 A1**
(43) Veröffentlichungstag der Anmeldung: **22.06.2022**
(21) Anmeldenummer: 20216044.6
(22) Anmeldetag: 21.12.2020
(51) Int. Cl.: G06Q 50/00, G06Q 10/10

(54) **VERFAHREN, COMPUTER-PROGRAMM-PRODUKT UND MODELLIERUNGSWERKZEUG ZUM ERSTELLEN EINES EIN ZU ENTWICKELNDES, TECHNISCHES SYSTEM REPRÄSENTIERENDEN SYSTEMMODELLS ALS DIGITALER SYSTEM-ZWILLING**

(71) Anmelder: Siemens Aktiengesellschaft, 80333 München (DE)
(72) Erfinder: Regnat, Nikolaus, 81827 München (DE); Winhuysen, Jan, 80469 München (DE)

(57) **Zusammenfassung**

Um ein ein zu entwickelndes, technisches System (SYₜ) repräsentierendes Systemmodell (SYMD) als Digitalen System-Zwilling (DSYZ) zu erstellen, bei dem textuelle Systemarchitekturbeschreibungen in modellbasierte Systemarchitekturbeschreibungen automatisiert überführt werden, wird es vorgeschlagen,
1) im Zuge der Entwicklung des technischen Systems (SYₜ) von zumindest einer Teilarchitektur des Systems (SYₜ) eine textuelle Systemarchitekturbeschreibung (SYABₜₓ) in eine modellbasierte Systemarchitekturbeschreibung (SYAB_{mb}) zu überführen und damit das Systemmodell (SYMD) entweder initial zu generieren oder zu erweitern,
2) durch eine computergestützte Überführungsorchestrierung (ÜFO), bei der mit einer benutzerbasierten Daten- und Befehlseingabe sowie einer logikbasierten Datenbearbeitung und Befehlsumsetzung nach regelsatzbasierter Maßgabe die Überführung orchestriert wird,
- in einer ersten Orchestrierungsphase (OP-1) zur Überführung der textuellen Systemarchitekturbeschreibung (SYABₜₓ) für ein Systementwicklungswerkzeug mit dem Systemmodell (SYMD) als Überführungszielmodell Überführungsregeln zur Identifikation von Teilaspekten einer Systemarchitektur des zu entwickelnden technischen Systems (SYₜ) zu ermitteln,
- in einer zweiten Orchestrierungsphase (OP-2) die Überführung der textuellen Systemarchitekturbeschreibung (SYABₜₓ) in die modellbasierte Systemarchitekturbeschreibung (SYAB_{mb}) iterativ (IVW) für eine Teilaspekt-basierte Beschreibung der Systemarchitektur unter Einhaltung der ermittelten Überführungsegeln umzusetzen.

## Beschreibung

Die Erfindung bezieht sich auf ein Verfahren zum Erstellen eines ein zu entwickelndes, technisches System repräsentierenden Systemmodells als Digitaler System-Zwilling gemäß dem Oberbegriff des Patentanspruches 1, ein Computer-Programm-Produkt zum Erstellen eines ein zu entwickelndes, technisches System repräsentierenden Systemmodells als Digitaler System-Zwilling gemäß dem Oberbegriff des Patentanspruches 2 und ein Modellierungswerkzeug zum Erstellen eines ein zu entwickelndes, technisches System repräsentierenden Systemmodells als Digitaler System-Zwilling gemäß dem Oberbegriff des Patentanspruches 3.

Bei der Entwicklung komplexer Systeme von komplexen Systemen unterschiedlicher technischer Domäne, im Folgenden als technisches System bezeichnet, ist es üblich, graphische Modellierungswerkzeuge zu benutzen, um z.B. Systemmodelle für Architekturen konsistent zu beschreiben. Für die weiteren Entwicklungsarbeit an dem technischen System müssen Modellinformationen linearisiert und mit weiteren Beschreibungen ergänzt werden. Für diese Linearisierung sind jedoch Maßnahmen erforderlich, welche eine aufwändige Entwicklung und Pflege ermöglichen und dabei sicherstellen, dass die von (menschlichen) Nutzern geforderte Qualität erreicht wird.

Die genannten technischen Domänen können beliebig sein. So sind es beispielsweise, nicht abschließend aufgezählt: Automatisierungstechnik, Energietechnik, Kommunikationstechnik, Medizintechnik, Fahrzeugtechnik betreffend Fahrzeuge zu Straße, Schiene, Wasser oder Luft.

Nach aktuellem Stand der Technik werden graphische Modellierungswerkzeuge genutzt, um z.B. Architekturen mit Hilfe von Modellen zu beschreiben. Im Anschluss kann dann aus diesen Modellen mit Hilfe von Dokumentengeneratoren ein einfach zu lesendes Dokument generiert werden. Die Entwicklung und Pflege dieser Dokumentengeneratoren ist dabei jedoch sehr aufwändig und erfordert darüber hinaus eine beständige Pflege.

Ein anderer, weit verbreiteter Ansatz besteht darin manuell Dokumente zu erstellen und diese nach Bedarf mit Bildern oder Graphiken anzureichern. Dabei entstehen jedoch oftmals sehr inkonsistente Dokumente, welche nicht die erforderlichen Qualitätsansprüche üblicher Prozessvorgaben erfüllen.

Die der Erfindung zugrundeliegende Aufgabe besteht darin, ein Verfahren, ein Computer-Programm-Produkt und ein Modellierungswerkzeug zum Erstellen eines ein zu entwickelndes, technisches System repräsentierenden Systemmodells als Digitaler System-Zwilling anzugeben, bei dem textuelle Systemarchitekturbeschreibungen in modellbasierte Systemarchitekturbeschreibungen automatisiert überführt werden.

Die vorstehend bezeichnete Aufgabe wird ausgehend von dem im Oberbegriff des Patentanspruches 1 definierten Verfahren durch die im Kennzeichen des Patentanspruches 1 angegebenen Merkmale gelöst.

Darüber hinaus wird diese Aufgabe ausgehend von dem im Oberbegriff des Patentanspruches 2 definierten Computer-Programm-Produkt durch die im Kennzeichen des Patentanspruches 2 angegebenen Merkmale gelöst.

Weiterhin wird diese Aufgabe ausgehend von dem im Oberbegriff des Patentanspruches 3 definierten Modellierungswerkzeug durch die im Kennzeichen des Patentanspruches 3 angegebenen Merkmale gelöst.

Die der Erfindung zugrundeliegende Idee gemäß der in den Ansprüchen 1, 2 und 3 [Anspruch 1 betreffend ein Verfahren; Anspruch 2 betreffend ein Computer-Programm-Produkt; Anspruch 3 betreffend ein Modellierungswerkzeug] jeweils angegebenen technischen Lehre besteht darin, dass
a) im Zuge der Entwicklung des technischen Systems von zumindest einer Teilarchitektur des Systems eine textuelle Systemarchitekturbeschreibung in eine modellbasierte Systemarchitekturbeschreibung überführt und damit das Systemmodell entweder initial generiert oder erweitert werden,
b) durch eine computergestützte Überführungsorchestrierung, bei der mit einer benutzerbasierten Daten- und Befehlseingabe
sowie einer logikbasierten Datenbearbeitung und Befehlsumsetzung nach regelsatzbasierter Maßgabe die Überführung orchestriert wird,
b1) in einer ersten Orchestrierungsphase zur Überführung der textuellen Systemarchitekturbeschreibung für ein Systementwicklungswerkzeug mit dem Systemmodell als Überführungszielmodell Überführungsregeln zur Identifikation von Teilaspekten einer Systemarchitektur des zu entwickelnden technischen Systems ermittelt werden,
b2) in einer zweiten Orchestrierungsphase die Überführung der textuellen Systemarchitekturbeschreibung in die modellbasierte Systemarchitekturbeschreibung iterativ für eine Teilaspekt-basierte Beschreibung der Systemarchitektur unter Einhaltung der ermittelten Überführungsegeln umgesetzt wird.

Im Gegensatz zu den bekannten Lösungen ist es mit der vorstehend vorgeschlagenen Vorgehensweise möglich, eine generische Implementierung zu entwickeln, welche eine aufwändige Anpassung und beständige Wartung vermeidet. Darüber hinaus kann sich der Nutzer oder Anwender, der die vorgeschlagene Vorgehensweise nutzt oder umsetzt, bei der Entwicklung des technisches System durch das Erstellen des das System repräsentierenden Systemmodells als Digitaler System-Zwilling auf wesentlichen Aspekte bei der Systementwicklung konzentrieren, nämlich der Erstellung des textbasierten oder menschenlesbaren Dokumentes, das die textuelle Systemarchitekturbeschreibung enthält, während im Hintergrund das konsistente Systemmodell mit der modellbasierten Systemarchitekturbeschreibung erstellt oder aufgebaut wird.

Zudem weisen die mit der vorgeschlagenen Vorgehensweise erstellten modellbasierten Dokumente oder Systemarchitekturbeschreibungen eine wesentlich höhere Konsistenz auf, und damit Qualität auf als manuell erstellte Dokumente oder Systemarchitekturbeschreibungen.

Weitere Vorteile der Erfindung ergeben sich aus den Unteransprüchen sowie der nachfolgenden Beschreibung eines Ausführungsbeispiels der Erfindung anhand der FIGUREN 1 bis 2 erläutert. Diese zeigen:
- FIGUR 1: Szenario zum Erstellen eines ein zu entwickelndes, technisches System repräsentierenden Systemmodells als Digitaler System-Zwilling,
- FIGUR 2: Ablaufdiagramm für das Erstellen des das zu entwickelnde, technische System repräsentierenden Systemmodells als den Digitalen System-Zwilling gemäß dem in der FIGUR 1 dargestellten Szenario.

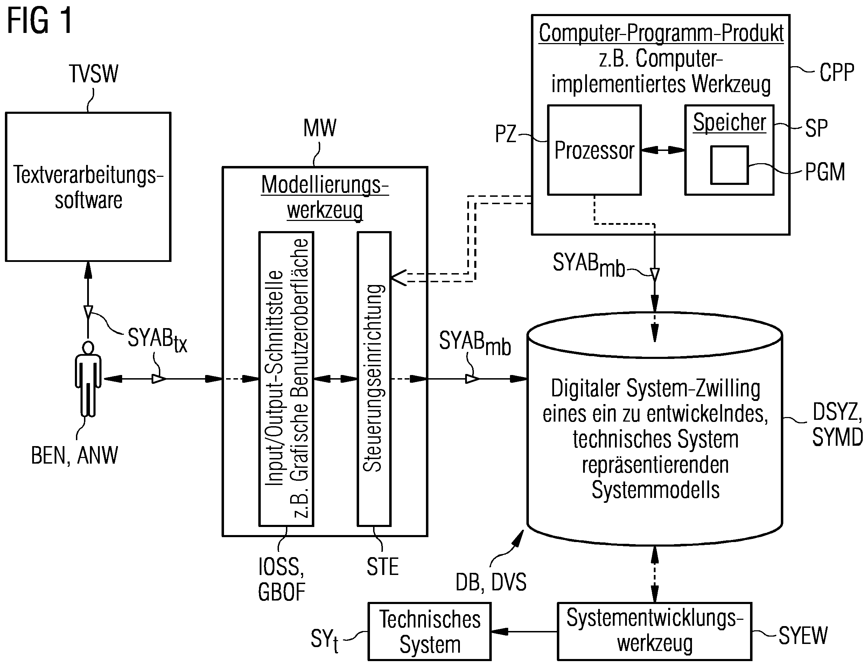

FIGUR 1 zeigt ein Szenario zum Erstellen eines ein zu entwickelndes, technisches System SYₜ repräsentierenden Systemmodells SYMD als Digitaler System-Zwilling DSYZ. Für diese Systementwicklung ist gemäß dem dargestellten Szenario ein Systementwicklungswerkzeug SYEW vorgesehen, das zu diesem Zweck auf eine Datenbank DB oder auf ein Datenverarbeitungssystem DVS mit dem darin als den Digitalen System-Zwilling DSYZ abgelegten Systemmodell SYMD zugreift. Mit diesen Zugriffen auf die Datenbank DB oder dem Datenverarbeitungssystem DVS werden Modellinformationen des Systemmodells SYMD für die Systementwicklung heruntergeladen.

Das technische System SYₜ und das Systementwicklungswerkzeug SYEW sind Gegenstände einer "physikalischen Welt", in der das technische System SYₜ gemäß der eingangs angegebenen Definition für technische Domänen z.B. im Bereich der Medizintechnik ein Computertomograph oder ein Magnetresonanztomograph oder im Bereich der Energietechnik eine Windkraftanlage oder im Bereich der Fahrzeugtechnik ein Personenkraftwagen (Auto) sein kann und das Systementwicklungswerkzeug SYEW vorzugsweise als Arbeitsplatzrechner (Workstation) oder Personal Computer ausgebildet ist.

Ein weiterer Gegenstand der "physikalischen Welt" gemäß dem dargestellten Szenario ist ein Modellierungswerkzeug MW zum Erstellen des Digitalen System-Zwillings DSYZ, das auch wieder vorzugsweise als Arbeitsplatzrechner (Workstation) oder Personal Computer ausgebildet ist.

Sowohl das Systementwicklungswerkzeug SYEW als auch das Modellierungswerkzeug MW sind insofern das Bindeglied zu einer "digitalen Welt" als beide auf den Digitalen System-Zwilling DSYZ zugreifen, das Systementwicklungswerkzeug SYEW zum Herunterladen der Modellinformationen des Systemmodells SYMD für die Systementwicklung und das Modellierungswerkzeug MW zum Erstellen des Digitalen System-Zwillings DSYZ oder des Systemmodells SYMD.

Um diesen Digitalen System-Zwilling DSYZ oder das Systemmodell SYMD für das Entwickeln des technischen Systems SYₜ von zumindest einer Teilarchitektur des Systems SYₜ erstellen zu können, weist das Modellierungswerkzeug MW eine Steuerungseinrichtung STE und eine mit der Steuerungseinrichtung STE verbundene und vorzugsweise als Grafische Benutzeroberfläche GBOF ausgebildete Input/Output-Schnittstelle IOSS für Benutzereingaben und -ausgaben eines Benutzers BEN oder Anwenders ANW des Modellierungswerkzeugs MW auf.

Die Steuerungseinrichtung STE ist für die Entwicklung des technischen Systems SYₜ und die Zugriffe auf den Digitalen Zwilling DZ mit der Datenbank DB oder dem Datenverarbeitungssystem DVS verbunden.

Das Erstellen des Digitalen System-Zwillings DSYZ oder des Systemmodells SYMD wird aber weder von dem Modellierungswerkzeug MW noch von der Steuerungseinrichtung STE als solches durchgeführt, sondern die Weitergabe ist Gegenstand eines weiteren digitalen Bausteins in der "digitalen Welt". Dieser digitale Baustein ist ein Computer-Programm-Produkt CPP zum Erstellen des Digitalen System-Zwillings DSYZ und im Zuge dessen zum Entwickeln des technischen Systems SYₜ, das als Computer-implementiertes Werkzeug ausgebildet ist und vorzugsweise eine Anwendungssoftware - auch als "APP" bezeichnet - darstellt.

Weiterhin weist das Computer-Programm-Produkt CPP einen nicht-flüchtigen, lesbaren Speicher SP, in dem prozessorlesbare Steuerprogrammbefehle eines Programm-Moduls PGM zum Erstellen des Digitalen System-Zwillings DSYZ oder des Systemmodells SYMD gespeichert sind, sowie einen mit dem Speicher SP verbundenen Prozessor PZ, der die Steuerprogrammbefehle des Programm-Moduls PGM zur Systemmodellerstellung aufweist.

Dieses Computer-Programm-Produkt CPP, das als Computer-implementiertes Werkzeug oder die "APP" ist zum referenzmodellbasierten, anforderungsbezogenen Entwickeln des technischen Systems SYₜ in die Steuerungseinrichtung STE ladbar [in der FIGUR 1 ist durch den gestrichelten Doppelpfeil (Pfeil mit doppelter Basis) dargestellt] und kann unabhängig von dem Modellierungswerkzeug MW entwickelt und vertrieben werden.

Im Zuge der Entwicklung der zumindest einen Teilarchitektur des Systems SYₜ wird von dem Benutzer BEN oder Anwender ANW des Modellierungswerkzeugs MW eine textuelle Systemarchitekturbeschreibung SYABₜₓ aus einer Textverarbeitungssoftware TVSW in die als die Grafische Benutzeroberfläche GBOF ausgebildete Input/Output-Schnittstelle IOSS eingegeben.

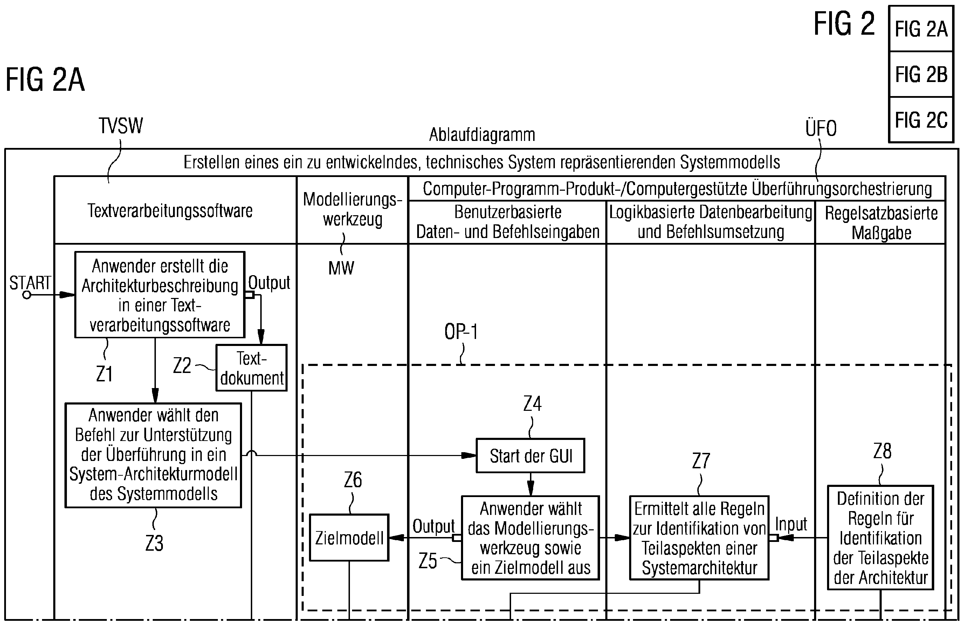

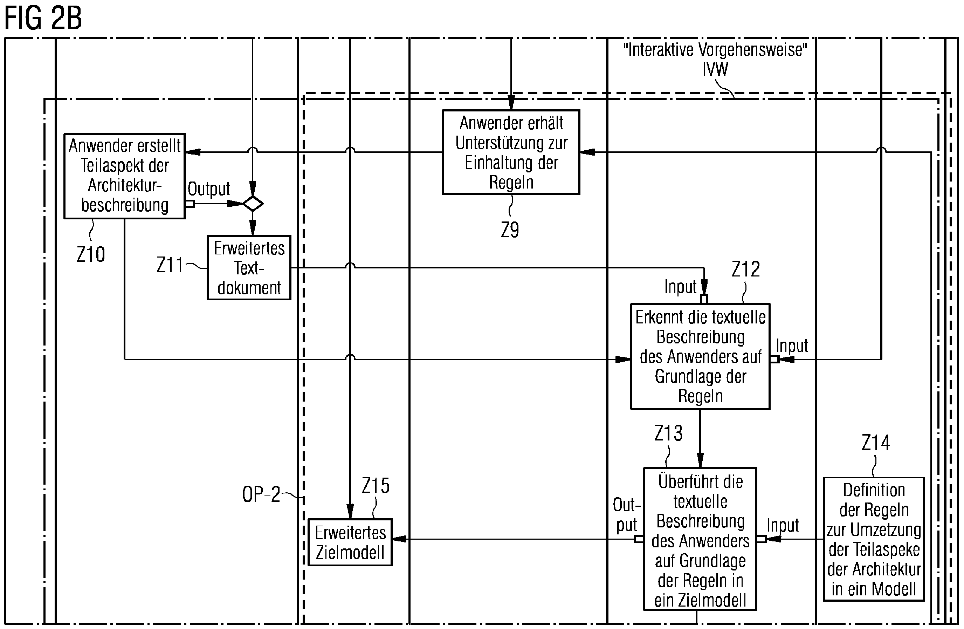

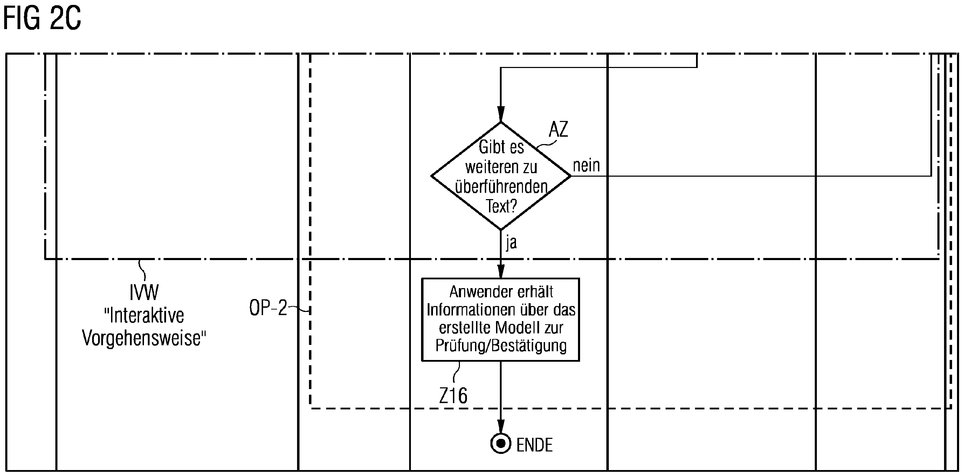

Wie das Erstellen des Digitalen System-Zwillings DSYZ oder des Systemmodells SYMD im Zuge der zumindest einen Teilarchitektur des Systems SYₜ gemäß dem dargestellten Szenario funktioniert, bei dem die textuelle Systemarchitekturbeschreibung SYABₜₓ in eine modellbasierte Systemarchitekturbeschreibung SYAB_{mb} überführt wird und damit das Systemmodell SYMD entweder initial generiert oder erweitert wird, sowie in dem Modellierungswerkzeug MW und in dem Computer-Programm-Produkt CPP abläuft und durchgeführt wird, wird nun im Zusammenhang mit FIGUR 2 erläutert.

FIGUR 2 zeigt ein Ablaufdiagramm für das Erstellen des das zu entwickelnde, technische System SYₜ repräsentierenden Systemmodells SYMD als den Digitalen System-Zwilling DSYZ gemäß dem in der FIGUR 1 dargestellten Szenario. Gemäß diesem Ablaufdiagramm wird die Erstellung des Systemmodells SYMD oder des Digitalen System-Zwillings DSYZ für die Entwicklung des technischen Systems SYₜ durch im Wesentlichen durch eine Überführungsorchestrierung ÜFO, bei der szenariogemäß, gestützt durch das Computer-Programm-Produkt CPP oder computergestützt die Überführung der textuellen Systemarchitekturbeschreibung SYABₜₓ in die modellbasierte Systemarchitekturbeschreibung SYAB_{mb} und damit die initiale Generierung oder die Erweiterung des Systemmodells SYMD oder des Digitalen System-Zwillings DSYZ orchestriert wird.

Die Überführungsorchestrierung ÜFO, gemäß der jede Überführung mit einer benutzerbasierten Daten- und Befehlseingabe sowie einer logikbasierten Datenbearbeitung und Befehlsumsetzung nach regelsatzbasierter Maßgabe orchestriert wird, unterteilt sich nach dem in der FIGUR 2 dargestellten Ablaufdiagramm in zwei Orchestrierungsphasen, einer ersten Orchestrierungsphase OP-1 und einer zweiten Orchestrierungsphase OP-2.

Nach regelsatzbasierter Maßgabe bedeutet dabei, dass Regeln maßgebend definieren, welche Informationen, z.B. Aspekte einer Systemarchitektur, relevant für die Erstellung des Systemmodells sind. Eine Regel definiert welche Informationen, z.B. Teilaspekt einer Beschreibung des Systems oder der Systemarchitektur, in welcher Art und Weise überführt werden sollen.

Die Regeln bestimmen dabei im Detail:
- Wie die jeweilige Information identifiziert werden kann.
- Wie die jeweilige Information in das Systemmodell transformiert werden soll.

Beispiel: in der textuellen Beschreibung werden Schnittstellen des technischen Systems mit einer Tabelle mit definierten Spalten (Name der Schnittstelle, Beschreibung der Schnittstelle, physikalischer Stecker der Schnittstelle etc.) beschrieben. Die Tabellen selbst werden mit der Überschrift "Schnittstellen einer Komponente des Modells" markiert. Eine Regel beschreibt nun diese Art von Tabellen für Schnittstellen und beschreibt zudem wie die Transformation in das Modell erfolgen soll. So könnte es im Modell ein Element "Schnittstelle" geben welches ebenfalls Eigenschaften wie "Name" oder "Beschreibung" hat. Andere Eigenschaften wie "physikalischer Stecker" benötigen zum Beispiel aber eine aufwändigere Transformation, da es im Modell z.B. eigene Elemente für physikalische Stecker gibt und diese dann referenziert werden müssen.

Die Systemmodellerstellung startet gemäß dem Ablaufdiagramm damit, dass in einem ersten Zustand Z1 der Anwender ANW oder Benutzer BEN nach der FIGUR 1 in der Textverarbeitungssoftware TVSW die textuelle Systemarchitekturbeschreibung SYABₜₓ erstellt wird. Anschließend werden von dem Anwender ANW oder Benutzer BEN in einem zweiten Zustand Z2 ein entsprechendes Textdokument erzeugt und in einem dritten Zustand Z3 von dem Anwender ANW oder Benutzer BEN ein Befehl zur Unterstützung der Überführung in ein System-Architekturmodell des Systemmodells ausgewählt.

Dies ist der Übergang von der Textverarbeitungssoftware TVSW über das Modellierungswerkzeug MW, wo die textuelle, in das Textdokument eingebettete Systemarchitekturbeschreibung SYABₜₓ eingegeben wird (vgl. FIGUR 1), zur ersten Orchestrierungsphase OP-1 der durch das Computer-Programm-Produkt CPP gestützten oder computergestützten Überführungsorchestrierung ÜFO. Dabei wird zunächst im Zuge der benutzerbasierten Daten- und Befehlseingabe bei der Überführungsorchestrierung ÜFO in einem vierten Zustand Z4 die Grafische Benutzeroberfläche GBOF (engl. Graphical User Interface <GUI>) gestartet.

Auf der Basis der erstellten Systemarchitekturbeschreibung SYABₜₓ erstellt und des Textdokument (vgl. Zustände Z1 und Z2) und der Befehlsauswahl (vgl. Zustand Z3) werden in der ersten Orchestrierungsphase OP-1, in der es darum geht, für das Systementwicklungswerkzeug SYEW mit dem Systemmodell SYMD als Überführungszielmodell Überführungsregeln zur Identifikation von Teilaspekten einer Systemarchitektur des zu entwickelnden technischen Systems SYₜ zu ermitteln, in einem fünften Zustand Z5 im Zuge der benutzerbasierten Daten- und Befehlseingabe bei der Überführungsorchestrierung ÜFO das Modellierungswerkzeug MW und ein mögliches Zielmodell für die Überführung ausgewählt.

Zielmodell bezieht sich rein auf den Ablageort in der Datenbank DB oder in dem Datenverarbeitungssystem DVS, wo die textuelle Systemarchitekturbeschreibung SYABₜₓ mit der modellbasierte Systemarchitekturbeschreibung SYAB_{mb} überführt werden soll. Das kann so z.B. die Datenbank DB sein.

Aus dem fünften Zustand Z5 wird im Zuge der benutzerbasierten Daten- und Befehlseingabe bei der Überführungsorchestrierung ÜFO das ausgewählte Zielmodell in einem sechsten Zustand Z6 dem Modellierungswerkzeug MW übergeben.

Darüber hinaus werden im Zuge der logikbasierten Datenbearbeitung und Befehlsumsetzung bei der Überführungsorchestrierung ÜFO in einem siebten Zustand Z7 alle Regeln (Überführungsregeln) zur Identifikation der Teilaspekte der Systemarchitektur ermittelt.

Für diese Ermittlung der Regeln zur Identifikation der Teilaspekte der Systemarchitektur werden im Zuge der regelbasierten Maßgabe bei der Überführungsorchestrierung ÜFO in einem achten Zustand Z8 die Regeln zur Identifikation der Teilaspekte der Systemarchitektur definiert.

Mit der Ermittlung der Regeln zur Identifikation der Teilaspekte der Systemarchitektur im Zuge der logikbasierten Datenbearbeitung und Befehlsumsetzung bei der Überführungsorchestrierung ÜFO in dem siebten Zustand Z7 findet gemäß der Überführungsorchestrierung ÜFO der Übergang von der ersten Orchestrierungsphase OP-1 zur zweiten Orchestrierungsphase OP-2 statt.

Gemäß der zweiten Orchestrierungsphase OP-2 bei der Zugriffsorchestrierung ZGO wird die Überführung der textuellen Systemarchitekturbeschreibung SYABₜₓ in die modellbasierte Systemarchitekturbeschreibung SYAB_{mb} im Zuge einer iterativen Vorgehensweise IVW, also iterativ, für eine Teilaspekt-basierte Beschreibung der Systemarchitektur unter Einhaltung der ermittelten Überführungsegeln umgesetzt.

Diese iterative Vorgehensweise IVW in der zweiten Orchestrierungsphase OP-2 und in der FIGUR 2 zwischen Zuständen Z9 und Z15 des Ablaufdiagramms als Iterationsschleife dargestellt beginnt in einem neunten Zustand Z9 im Zuge der benutzerbasierten Daten- und Befehlseingabe bei der Überführungsorchestrierung ÜFO damit, dass der Anwender Unterstützung zur Einhaltung der ermittelten Regeln, den Überführungsregeln, erhält.

So erstellt der Anwender ANW in einem ersten Zustand Z10 in der Textverarbeitungssoftware TVSW einen Teilaspekt der Beschreibung der Systemarchitektur, worauf anschließend von dem Anwender ANW oder Benutzer BEN in einem elften Zustand Z11 das in dem zweiten Zustand Z2 erzeugte Textdokument erweitert wird.

Auf der Basis des erweiterten Textdokumentes (vgl. Zustand Z11) und der Befehlsauswahl (vgl. Zustand Z3) wird wieder im Zuge der logikbasierten Datenbearbeitung und Befehlsumsetzung bei der Überführungsorchestrierung ÜFO in einem zwölften Zustand Z12 die textuelle Beschreibung des Anwenders auf Grundlage der Regeln (Überführungsregeln) erfasst.

Daran anschließend wird ebenfalls im Zuge der logikbasierten Datenbearbeitung und Befehlsumsetzung bei der Überführungsorchestrierung ÜFO in einem dreizehnten Zustand Z13 die erfasste, textuelle Beschreibung des Anwenders auf Grundlage der Regeln in das Zielmodell überführt.

Für diese Überführung der textuellen Beschreibung werden im Zuge der regelbasierten Maßgabe bei der Überführungsorchestrierung ÜFO in einem vierzehnten Zustand Z14 die Regeln zur Umsetzung der Teilaspekte der Systemarchitektur in ein Modell (das Systemmodell) definiert. Außerdem wird ausgehend von dem dreizehnten Zustand Z13 im Zuge der logikbasierten Datenbearbeitung und Befehlsumsetzung bei der Überführungsorchestrierung ÜFO das Zielmodell, das in dem sechsten Zustand Z6 dem Modellierungswerkzeug MW übergeben worden ist, in einem fünfzehnten Zustand Z15 entsprechend der Überführung der textuellen Beschreibung erweitert.

Ist die textuelle Beschreibung in das Zielmodell überführt (vgl. Zustand Z13), dann wird in einem Abfragezustand AZ im Zuge der benutzerbasierten Daten- und Befehlseingabe bei der Überführungsorchestrierung ÜFO abgefragt, ob es weiteren zu überführenden Text gibt. Beim Abfrageergebnis "JA" wird im Zuge der benutzerbasierten Daten- und Befehlseingabe bei der Überführungsorchestrierung ÜFO in einem sechzehnten Zustand Z16 dem Anwender ANW oder Benutzer BEN Informationen über das erstellte Model, das Systemmodell, zur Prüfung (Bestätigung) zur Verfügung gestellt, wobei nach dem Erhalt der Informationen und der durchgeführten Prüfung die Überführungsorchestrierung ÜFO, die zwei Orchestrierungsphase OP-2 abgeschlossen und das Ende des Ablaufdiagramms erreicht sind, während es beim Abfrageergebnis "NEIN", die Iterationsschleife des Ablaufdiagramms im Sinne der iterativen Vorgehensweise IVW durchlaufend, zurück in den neunten Zustand Z9 im Zuge der benutzerbasierten Daten- und Befehlseingabe bei der Überführungsorchestrierung ÜFO geht.

## Patentansprüche

1. Verfahren, Computer-Programm-Produkt und Modellierungswerkzeug zum Erstellen eines ein zu entwickelndes, technisches System (SYₜ) repräsentierenden Systemmodells (SYMD) als Digitaler System-Zwilling (DSYZ), bei dem im Zuge der Entwicklung des technischen Systems (SYₜ) von zumindest einer Teilarchitektur des Systems (SYₜ) eine textuelle Systemarchitekturbeschreibung (SYABₜₓ) in eine modellbasierte Systemarchitekturbeschreibung (SYAB_{mb}) überführt wird und damit das Systemmodell (SYMD) entweder initial generiert oder erweitert wird,
**gekennzeichnet durch**
**a**) eine computergestützte Überführungsorchestrierung (ÜFO), bei der mit einer benutzerbasierten Daten- und Befehlseingabe sowie einer logikbasierten Datenbearbeitung und Befehlsumsetzung nach regelsatzbasierter Maßgabe die Überführung orchestriert wird, mit der
**a1**) in einer ersten Orchestrierungsphase (OP-1) zur Überführung der textuellen Systemarchitekturbeschreibung (SYABₜₓ) für ein Systementwicklungswerkzeug (SYEW) mit dem Systemmodell (SYMD) als Überführungszielmodell Überführungsregeln zur Identifikation von Teilaspekten einer Systemarchitektur des zu entwickelnden technischen Systems (SYₜ) ermittelt werden,
**a2**) in einer zweiten Orchestrierungsphase (OP-2) die Überführung der textuellen Systemarchitekturbeschreibung (SYABₜₓ) in die modellbasierte Systemarchitekturbeschreibung (SYAB_{mb}) iterativ (IVW) für eine Teilaspekt-basierte Beschreibung der Systemarchitektur unter Einhaltung der ermittelten Überführungsegeln umgesetzt wird.

2. Computer-Programm-Produkt (CPP) zum Erstellen eines ein zu entwickelndes, technisches System (SYₜ) repräsentierenden Systemmodells (SYMD) als Digitaler System-Zwilling (DSYZ) mit einem nicht-flüchtigen, lesbaren Speicher (SP), in dem prozessorlesbare Steuerprogrammbefehle eines Programm-Moduls (PGM) zum Erstellen des Systemmodells (SYMD) gespeichert sind, und einem mit dem Speicher (SP) verbundenen Prozessor (PZ), der die Steuerprogrammbefehle des Programm-Moduls (PGM) zur Systemmodellerstellung ausführt, wobei hierfür im Zuge der Entwicklung des technischen Systems (SYₜ) von zumindest einer Teilarchitektur des Systems (SYₜ) eine textuelle Systemarchitekturbeschreibung (SYABₜₓ) in eine modellbasierte Systemarchitekturbeschreibung (SYAB_{mb}) überführt wird und damit das Systemmodell (SYMD) entweder initial generiert oder erweitert wird,
**dadurch gekennzeichnet, dass**
der Prozessor (PZ) und das Programm-Modul (PGM) zur Erstellung des Systemmodells (SYMD) derart ausgebildet sind, dass
**a**) im Zuge einer Überführungsorchestrierung (ÜFO), bei der mit einer benutzerbasierten Daten- und Befehlseingabe sowie einer logikbasierten Datenbearbeitung und Befehlsumsetzung nach regelsatzbasierter Maßgabe die Überführung orchestriert wird,
**a1**) in einer ersten Orchestrierungsphase (OP-1) zur Überführung der textuellen Systemarchitekturbeschreibung (SYABₜₓ) für ein Systementwicklungswerkzeug (SYEW) mit dem Systemmodell (SYMD) als Überführungszielmodell Überführungsregeln zur Identifikation von Teilaspekten einer Systemarchitektur des zu entwickelnden technischen Systems (SYₜ) ermittelt werden,
**a2**) in einer zweiten Orchestrierungsphase (OP-2) die Überführung der textuellen Systemarchitekturbeschreibung (SYABₜₓ) in die modellbasierte Systemarchitekturbeschreibung (SYAB_{mb}) iterativ für eine Teilaspekt-basierte Beschreibung der Systemarchitektur unter Einhaltung der ermittelten Überführungsegeln umgesetzt wird.

3. Modellierungswerkzeug (MW) zum Erstellen eines ein zu entwickelndes, technisches System (SYₜ) repräsentierenden Systemmodells (SYMD) als Digitaler System-Zwilling (DSYZ), bei dem im Zuge der Entwicklung des technischen Systems (SYₜ) von zumindest einer Teilarchitektur des Systems (SYₜ) eine textuelle Systemarchitekturbeschreibung (SYABₜₓ) in eine modellbasierte Systemarchitekturbeschreibung (SYAB_{mb}) überführt wird und damit das Systemmodell (SYMD) entweder initial generiert oder erweitert wird,
mit einer Steuerungseinrichtung (STE) und einer mit der Steuerungseinrichtung (STE) verbundene Input/Output-Schnittstelle (IOSS) für Benutzereingaben und -ausgaben, wobei die Steuerungseinrichtung (STE) für die Systemmodellerstellung mit einer Datenbank (DB) zur Speicherung des Digitalen Zwillings (DZ) verbunden ist,
**gekennzeichnet durch**
ein Computer-Programm-Produkt (CPP) nach Anspruch 2, das zur Durchführung des Verfahrens nach einem der Anspruch 1 in die Steuerungseinrichtung (STE) ladbar ist.
